(19) Europäisches Patentamt
European Patent Office
Office européen des brevets

(11) **EP 4 318 298 B1**

(12) **EUROPEAN PATENT SPECIFICATION**

(45) Date of publication and mention
of the grant of the patent:
**20.05.2026  Bulletin 2026/21**

(21) Application number: **23744348.6**

(22) Date of filing: **09.05.2023**

(51) International Patent Classification (IPC):
**G06F 30/398** *(2020.01)*     **G03F 1/36** *(2012.01)*

(52) Cooperative Patent Classification (CPC):
**G03F 1/36; G06N 3/0455; G06N 3/0464;
G06N 3/096;** G06F 30/27; G06F 30/392;
G06F 30/398; Y02P 90/30

(86) International application number:
**PCT/CN2023/092892**

(87) International publication number:
**WO 2023/241267 (21.12.2023 Gazette 2023/51)**

(54) **TRAINING METHOD AND APPARATUS FOR LITHOGRAPHIC-MASK GENERATION MODEL,
AND DEVICE AND STORAGE MEDIUM**

TRAININGSVERFAHREN UND -VORRICHTUNG FÜR EIN
LITHOGRAFIEMASKENERZEUGUNGSMODELL SOWIE VORRICHTUNG UND
SPEICHERMEDIUM

PROCÉDÉ ET APPAREIL D'ENTRAÎNEMENT POUR MODÈLE DE GÉNÉRATION DE MASQUE
LITHOGRAPHIQUE, DISPOSITIF, ET SUPPORT DE STOCKAGE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **14.06.2022  CN 202210673948**

(43) Date of publication of application:
**07.02.2024  Bulletin 2024/06**

(73) Proprietor: **Tencent Technology (Shenzhen)
Company Limited
Shenzhen, Guangdong, 518057 (CN)**

(72) Inventors:
• **MA, Xingyu**
  **Shenzhen, Guangdong 518057 (CN)**
• **HAO, Shaogang**
  **Shenzhen, Guangdong 518057 (CN)**
• **ZHANG, Shengyu**
  **Shenzhen, Guangdong 518057 (CN)**

(74) Representative: **Gunzelmann, Rainer
Wuesthoff & Wuesthoff
Patentanwälte und Rechtsanwalt PartG mbB
Schweigerstraße 2
81541 München (DE)**

(56) References cited:
WO-A1-2022/008174     CN-A- 108 228 981
CN-A- 111 788 589     CN-A- 113 238 460
CN-A- 114 326 328     DE-A1- 102018 207 876
US-A1- 2020 380 362     US-A1- 2021 216 697

• HAO-CHIANG SHAO; CHAO-YI PENG; JUN-REI
WU; CHIA-WEN LIN; SHAO-YUN FANG; PIN-YEN
TSAI; YAN-HSIU LIU: "From IC Layout to Die
Photo: A CNN-Based Data-Driven Approach",
ARXIV.ORG, CORNELL UNIVERSITY LIBRARY,
201 OLIN LIBRARY CORNELL UNIVERSITY
ITHACA, NY 14853, 11 February 2020
(2020-02-11), 201 Olin Library Cornell University
Ithaca, NY 14853
, XP081598070

**Description**

TECHNICAL FIELD

Embodiments of this disclosure relate to the field of chip and machine learning technologies, and in particular, to a training method and apparatus for a lithographic mask generation model, a device and a storage medium.

BACKGROUND

In the chip production process, it is necessary to obtain a mask map corresponding to each chip layout for lithographic process exposure.

In related technologies, a lithographic mask generation model may generate a predictive mask map in the training process, and it is necessary to adopt a lithographic physical model (Lithography Simulation, LS) to generate a wafer pattern corresponding to the predictive mask map in the training process of the lithographic mask generation model, so as to update the lithographic mask generation model.

In the above related technologies, the processing process of generating the wafer pattern by the lithographic physical model is more complex and the generation speed is relatively slow, which affects the training efficiency of the lithographic mask generation model.

US 2020/380362 A1 discloses a training method for a lithographic mask generation model.

SUMMARY

Embodiments of this disclosure provide a training method and apparatus for a lithographic mask generation model, a device and a storage medium, and can improve the training efficiency of a lithographic mask generation model. The technical solutions are as follows.

According to an aspect of the embodiments of this disclosure, a training method for a lithographic mask generation model is provided. The method is executed by a computer device, and the method includes:

generating a predictive mask map corresponding to a chip layout through a lithographic mask generation model; the lithographic mask generation model being a neural network model for generating the predictive mask map;

generating a predictive wafer pattern corresponding to the predictive mask map through a pre-trained wafer pattern generation model, the wafer pattern generation model being a neural network-based machine learning model;

determining a model precision evaluation index according to the predictive mask map, and determining a mask quality evaluation index according to the predictive wafer pattern; the model precision evaluation index being used for representing a mask prediction precision of the lithographic mask generation model, and the mask quality evaluation index being used for representing a quality of the predictive mask map;

determining a training loss according to the model precision evaluation index and the mask quality evaluation index; and

adjusting at least one parameter of the lithographic mask generation model according to the training loss.

According to an aspect of the embodiments of this disclosure, a training apparatus for a lithographic mask generation model is provided. The apparatus includes:

a mask generation module, configured to generate a predictive mask map corresponding to a chip layout through a lithographic mask generation model; the lithographic mask generation model being a neural network model for generating the predictive mask map;

a pattern generation module, configured to generate a predictive wafer pattern corresponding to the predictive mask map through a pre-trained wafer pattern generation model, the wafer pattern generation model being a neural network-based machine learning model;

a loss determination module, configured to determine a model precision evaluation index according to the predictive mask map, and determine a mask quality evaluation index according to the predictive wafer pattern; the model precision evaluation index being used for representing a mask prediction precision of the lithographic mask generation model, and the mask quality evaluation index being used for representing a quality of the predictive mask map;

determine a training loss according to the model precision evaluation index and the mask quality evaluation index; and

a parameter adjustment module, configured to adjust at least one parameter of the lithographic mask generation model according to the training loss.

According to an aspect of the embodiments of this disclosure, a computer device is provided. The computer device includes a processor and a memory, the memory storing a computer program, and the computer program being loaded and executed by the processor to implement the training method for a lithographic mask generation model.

According to an aspect of the embodiments of this disclosure, a computer readable storage medium is provided. The computer readable storage medium has a computer program stored therein, and the computer program is loaded and executed by a processor to implement the training method for a lithographic mask generation model

According to an aspect of the embodiments of this disclosure, a computer program product is provided. The computer program is stored in a computer readable storage medium. A processor of a computer device reads the computer program from the computer readable storage medium. The processor executes the computer program, so that the computer device executes the training method for a lithographic mask generation model.

The technical solutions provided in the embodiments of this disclosure may include the following beneficial effects:

In the process of training the lithographic mask generation model, the predictive wafer pattern is generated by the pre-trained machine learning model constructed based on a neural network, and the training loss is determined based on the generated predictive wafer pattern to update the parameter of the lithographic mask generation model, because a neural network model is adopted to generate the predictive wafer pattern, compared with the use of the lithographic physical model to generate the predictive wafer pattern, the amount of computation required is less and the calculation efficiency is higher, so the time required to generate the predictive wafer pattern is saved, thereby improving the training efficiency of the lithographic mask generation model.

BRIEF DESCRIPTION OF THE DRAWINGS

FIG. 1 is a flowchart of a training method for a lithographic mask generation model according to an embodiment of this disclosure.

FIG. 2 is a schematic diagram of a model training system according to an embodiment of this disclosure.

FIG. 3 is a flowchart of a training method for a lithographic mask generation model according to another embodiment of this disclosure.

FIG. 4 is a flowchart of a training method for a lithographic mask generation model according to another embodiment of this disclosure.

FIG. 5 is a flowchart of a training method for a lithographic mask generation model according to another embodiment of this disclosure.

FIG. 6 is a flowchart of a training method for a lithographic mask generation model according to another embodiment of this disclosure.

FIG. 7 is a schematic diagram of a wafer pattern generation model and a complexity evaluation model sharing a feature extraction network according to an embodiment of this disclosure.

FIG. 8 is a block diagram of a training apparatus for a lithographic mask generation model according to an embodiment of this disclosure.

FIG. 9 is a block diagram of a training apparatus for a lithographic mask generation model according to an embodiment of this disclosure.

FIG. 10 is a block diagram of a computer device according to an embodiment of this disclosure.

DESCRIPTION OF EMBODIMENTS

Artificial intelligence (AI) is a theory, method, technology, and application system that uses a digital computer or a machine controlled by a digital computer to simulate, extend, and expand human intelligence, perceive the environment, acquire knowledge, and use knowledge to obtain an optimal result. In other words, AI is a comprehensive technology in computer science and attempts to understand the essence of intelligence and produce a new intelligent machine that can react in a manner similar to human intelligence. AI is to study the design principles and implementation methods of various intelligent machines, to enable the machines to have the functions of perception, reasoning, and decision-making.

The AI technology is a comprehensive discipline, and relates to a wide range of fields including both hardware-level technologies and software-level technologies. The basic AI technologies generally include technologies such as a sensor, a dedicated AI chip, cloud computing, distributed storage, a big data processing technology, an operating/interaction system, and electromechanical integration. AI software technologies mainly include several major directions such as a computer vision technology, a speech processing technology, a natural language processing technology, and machine learning/deep learning.

Machine learning (ML) is a multi-field interdiscipline, and relates to a plurality of disciplines such as the probability theory, statistics, the approximation theory, convex analysis, and the algorithm complexity theory. ML specializes in studying how a computer simulates or implements a human learning behavior to obtain new knowledge or skills, and reorganize an existing knowledge structure, so as to keep improving its performance. ML is the core of AI, is a basic way to make the computer intelligent, and is applied to various fields of AI. ML and deep learning generally include technologies such as an artificial neural network, a belief network, reinforcement learning, transfer learning, inductive learning, and learning from demonstrations.

The embodiments of this disclosure adopt the machine learning technology to train the lithographic mask generation model, so that the lithographic mask generation model may generate a predictive mask map of higher precision, and provide a mask for the subsequent chip lithography process.

The method provided by the embodiments of this disclosure may also be applied to other links of integrated circuit design, such as chip logic circuit simulation, chip heat transport simulation, chip performance detection, chip dead pixel detection, light source-mask co-optimization and other electronic design automation (EDA) fields.

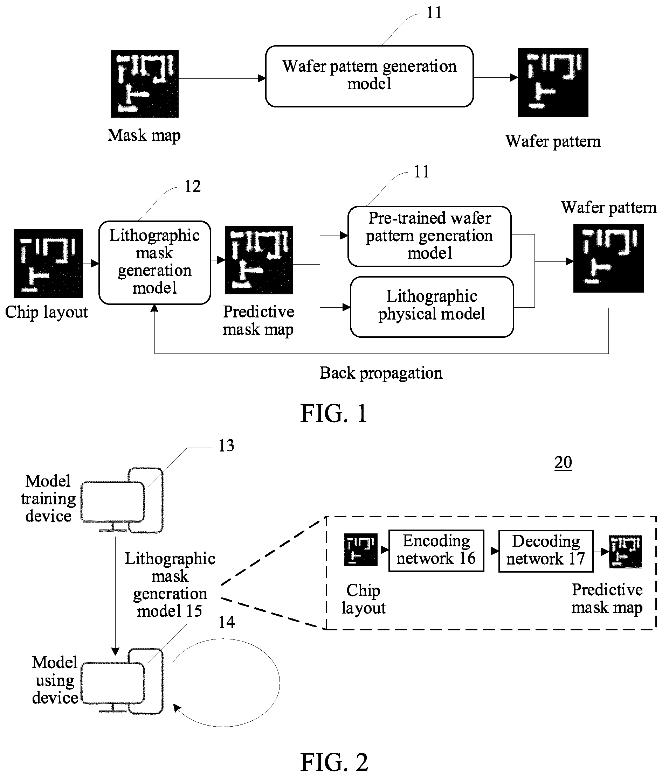

FIG. 1 of this disclosure provides a training method for a lithographic mask generation model. As shown in FIG. 1, the method may include the following steps: performing pre-training on a wafer pattern generation model 11 to obtain the pre-trained wafer pattern generation model 11; performing mask prediction on a chip layout by using a lithographic mask generation model 12, generating a predictive mask map, and calculating a model precision evaluation index according to a difference between the predictive mask map and a standard mask map corresponding to the chip layout; generating a predictive wafer pattern corresponding to the predictive mask map by using the pre-trained wafer pattern generation model 11, and calculating a mask quality evaluation index according to a difference between the predictive wafer pattern and the chip layout; generating a plurality of wafer patterns corresponding to the predictive mask map by using a lithographic physical model based on a plurality of different process parameters; determining, according to a difference between the plurality of wafer patterns, a complexity evaluation index corresponding to the predictive mask map; and training the lithographic mask generation model 12 according to the model precision evaluation index, the mask quality evaluation index, and the complexity evaluation index.

FIG. 2 illustrates is a schematic diagram of a model training system according to an embodiment of this disclosure. The model training system may be implemented as a training system for the lithographic mask generation model. The system 20 may include a model training device 13 and a model using device 14.

The model training device 13 may be an electronic device such as a computer, a server and an intelligence robot, or some other electronic devices with strong computing capability. The model training device 13 is configured to train a lithographic mask generation model 15. In the embodiment of this disclosure, the lithographic mask generation model 15 is a neural network model configured to generate a predictive mask map, and the model training device 13 may train the lithographic mask generation model 15 by means of machine learning, so that the lithographic mask generation model 15 has better performance.

The trained lithographic mask generation model 15 may be deployed in the model using device 14 to provide an image processing result (i.e., an automatic counting result). The model using device 14 may be a terminal device such as a personal computer (PC), a tablet computer, a smart phone, a wearable device, an intelligent robot, an intelligent voice interaction device, a smart home appliance, a vehicle-mounted terminal, an aircraft and a medical device, may also be a server, which is not limited in this disclosure.

In some embodiments, as shown in FIG. 2, the lithographic mask generation model 15 may include: an encoding network 16 and a decoding network 17. In some embodiments, the encoding network 16 is an encoding network including convolutional neural networks. Taking the number of convolutional layers being 8 as an example, after the chip layout is inputted, these 8 convolutional layers include 8, 16, 32, 64, 128, 256, 512, 1024 $3\times3$ filters respectively through a multi-layer two-dimensional convolutional neural network, and a batch normalization layer is established behind each convolutional layer, and a rectified linear unit (ReLU) is used as an activation function. The final output of the above 8 convolutional layers (dimension $(1, 1, 1024)$) is used as an input of the decoding network 17, and the decoding network 17 is composed of multi-layer deconvolutional neural networks. Taking the number of deconvolutional layers being 8 as an example, the first 7 convolutional layers include 1024, 512, 256, 128, 64, 32, 16 $3\times3$ filters respectively, and a batch normalization layer is established behind each deconvolutional layer, and a Leaky rectified linear unit (Leaky-ReLU) is used as an activation function. Finally, the deconvolutional layer includes a $3\times3$ filter and a sigmoid activation function gives a mask with the dimension $(256, 256, 1)$ and a value of 0 to 1, and then binary processing is performed on the mask to obtain a final predictive mask.

In some embodiments, the lithographic mask generation model 15 is a U-shaped image segmentation network U-Net. The U-Net includes an encoding network 16 and a decoding network 17. The encoding network 16 is configured to perform feature extraction (downsampling) on the chip layout, and the decoding network 17 is configured to perform upsampling and feature stitching to obtain a predictive mask. The computer device inputs the chip layout to the encoding network 16 for downsampling to obtain feature information corresponding to the chip layout, and the computer device performs upsampling and feature stitching on the feature information corresponding to the chip layout through the decoding network 17 to obtain a predictive mask map corresponding to the chip layout.

The embodiments of this disclosure may be applied to various scenes, including but not limited to chip design, cloud technology, artificial intelligence, chip manufacturing, intelligent transportation, assisted driving, etc.

The technical solutions of this disclosure are described below through some embodiments.

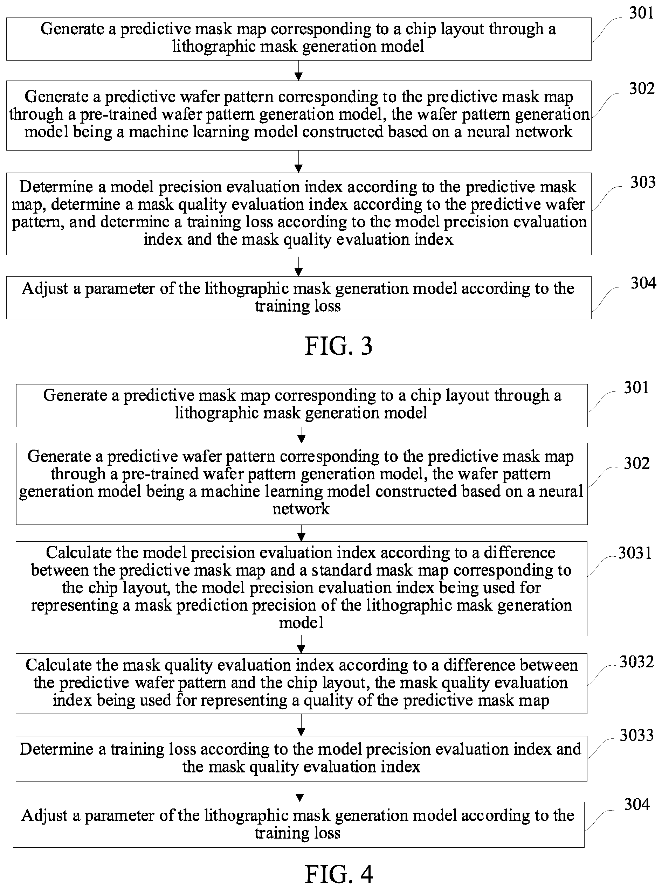

FIG. 3 illustrates a flowchart of a training method for a lithographic mask generation model according to an embodiment of this disclosure. In this embodiment, this embodiment is described by using an example in which the method is applied to the model training device described above. The method may include the following steps (301-304):

Step 301: Generate a predictive mask map corresponding to a chip layout through a lithographic mask generation model.

The lithographic mask generation model is a model that needs to be trained in the embodiments of this disclosure. In some embodiments, the chip layout is inputted to the lithographic mask generation model, and a predictive mask map corresponding to the chip layout is generated by the lithographic mask generation model.

The chip layout may be a chip design layout with annotations, that is, the chip layout may be an analog simulation layout. The chip design layout with annotations refers to a chip layouts that have generated corresponding standard mask maps.

The chip layout may also be an integrated circuit layout, which is a description of plane geometry in the physical condition of a real integrated circuit. The integrated circuit layout is a result of bottom-level step physical design in the integrated circuit design. Physical design converts a result of logical synthesis into a layout file through layout and routing techniques. This file contains information about the shape, area, and position of each hardware unit on the chip. In some embodiments, the type of the chip layout may be divided according to the chip level corresponding to the chip layout, such as a communication layer and a metal wire layer. In some embodiments, the type of the chip layout may also be divided according to the application field, such as quantum chips, home appliance chips, mobile phone chips, computer chips, wearable device chips, and industrial robot chips.

The standard mask map refers to a mask map obtained by optical proximity correction (OPC) of the chip layout, and the standard mask map is an annotation of the chip layout with annotations. Optical proximity correction refers to: a lithographic resolution enhancement technique that uses a computing method to correct a graphic on the mask so that a graphic projected on a photoresist meets the design requirements as much as possible. In the lithography process, the graphic on the mask is projected on the photoresist through an exposure system, and the graphic on the photoresist and the graphic on the mask are not exactly the same due to the imperfection and diffraction effect of the optical system. In a case that these distortions are not corrected, it may change the electrical performance of the produced circuit to a large extent. Optical proximity correction is a technique that makes an imaging result in the photoresist as close as possible to the mask graphic by adjusting the topological structure of a transparent region graphic on the lithographic mask, or adding a small sub-resolution auxiliary graphic to the mask. The OPC technique is also a technique that compensates for degradation of the imaging quality of the lithographic system by changing the amplitude of the transmitted light from the mask. The OPC is mainly used in the production of semiconductor devices.

Step 302: Generate a predictive wafer pattern corresponding to the predictive mask map through a pre-trained wafer pattern generation model, the wafer pattern generation model being a neural network-based machine learning model.

In some embodiments, the pre-trained wafer pattern generation model may generate a corresponding predictive wafer pattern based on the mask map. That is, the predictive mask map is inputted to the pre-trained wafer pattern generation model, and the pre-trained wafer pattern generation model may output a predictive wafer pattern corresponding to the predictive mask map.

The wafer pattern generation model is a neural network model configured to generate a predictive wafer pattern, and the wafer pattern generation model may be trained by means of machine learning, so that the wafer pattern generation model has better performance.

In some embodiments, the wafer pattern generation model is a U-shaped image segmentation network U-Net. The U-Net includes an encoding network and a decoding network. The encoding network is configured to perform feature extraction (downsampling) on the predictive mask map, and the decoding network is configured to perform upsampling and feature stitching to obtain a predictive wafer pattern. The computer device inputs the predictive mask map to the encoding network for downsampling to obtain feature information corresponding to the predictive mask map, and the computer device performs upsampling and feature stitching on the feature information corresponding to the predictive mask map through the decoding network to obtain a predictive wafer pattern corresponding to the predictive mask map.

In some embodiments, the encoding network in the wafer pattern generation model is an encoding network composed of convolutional neural networks. Taking the number of convolutional layers being 8 as an example, after the predictive mask map is inputted, these 8 convolutional layers include 8, 16, 32, 64, 128, 256, 512, 1024 $3\times3$ filters respectively through a multi-layer two-dimensional convolutional neural network, and a batch normalization layer is established behind each convolutional layer, and a rectified linear unit (ReLU) is used as an activation function. The final output of the above 8 convolutional layers (dimension (1, 1, 1024)) is used as an input of the decoding network, and the decoding network is composed of multi-layer deconvolutional neural networks. Taking the number of deconvolutional layers being 8 as an example, the first 7 convolutional layers include 1024, 512, 256, 128, 64, 32, 16 $3\times3$ filters respectively, and a batch normalization layer is established behind each deconvolutional layer, and a Leaky rectified linear unit (Leaky-ReLU) is used as an activation function. Finally, the predictive wafer pattern corresponding to the predictive mask map is obtained.

Since an acceleration operation may be easily performed on the neural network model by using a processor such as a central processing unit (CPU), its computation takes less time.

In some embodiments, a first data set is acquired. The first data set includes at least one mask map sample, and a standard wafer pattern corresponding to the mask map sample. The wafer pattern generation model is trained by using the first data set, to obtain the pre-trained wafer pattern generation model.

In some embodiments, OPC processing is performed on a chip layout sample, to obtain a mask map sample corresponding to the chip layout sample. A standard wafer pattern corresponding to the mask map sample is obtained through a second lithographic physical model. The second lithographic physical model is a mathematical physical simulation model based on the principle of optics. The first data set is constructed according to the mask map sample and the standard wafer pattern that have a corresponding relationship. The mask map sample refers to a mask map that has generated a corresponding standard wafer pattern.

In some embodiments, training the wafer pattern generation model may adopt the following loss function:

$$L = \left|\text{Wafer} - \text{Wafer}_{\text{pred}}\right|^2$$

Wafer represents the wafer pattern obtained by the lithographic physical model, Wafer$_{\text{pred}}$ represents the wafer pattern predicted by the wafer pattern generation model, and L represents the loss function value.

In some embodiments, the lithographic physical model (e.g., a second lithographic physical model) is a mathematical physical simulation model based on the principle of optics.

Optionally, first, the selected process parameter (such as a standard process parameter) and the mask map are inputted into the lithographic physical model, and the lithographic physical model generates light intensity distribution corresponding to the process parameter and the mask map. The light intensity distribution is converted into a wafer pattern corresponding to the process parameter and the mask map through the sigmoid function.

In some embodiments, the lithographic physical model is a partial coherent imaging system Hopkins diffraction lithographic physical model, the light intensity distribution I imaged on the wafer obtained by the lithographic physical model is obtained by the convolution of the mask map and a lithographic system kernel function h, and the kernel function is obtained by performing singular value decomposition on a cross-transfer coefficient of the lithographic system (such as 193 nm ring light source). In some embodiments, the lithographic physical model is defined as follows:

$$I(x, y) = \sum_{k=1}^{K} \omega_k |M(x, y) \otimes h_k(x, y)|^2$$

$h_k$ and $\omega_k$ are the $k^{\text{th}}$ kernel function after the singular value decomposition and a corresponding weight coefficient, respectively, (x,y) are data coordinates, M represents the mask, and I represents the light intensity distribution imaged on the lithographic physical model. Optionally, the first 24 kernel functions after the singular value decomposition and corresponding weight coefficients may be used, that is, K=24.

In some embodiments, the wafer pattern is obtained by the light intensity distribution imaged on the wafer through the following distribution function:

$$Z(x, y) = 1, I(x, y) \geq I_{th}$$

$$Z(x, y) = 0, I(x, y) < I_{th}$$

In some embodiments, Z is the light intensity distribution imaged on the wafer, $I_{th}$ represents the intensity value, and $I_{th}$ is 0.225. Optionally, $I_{th}$ may take other values in the [0, 1] interval, which is not specifically limited in the embodiments of this disclosure.

Step 303: Determine a model precision evaluation index according to the predictive mask map, and determine a mask quality evaluation index according to the predictive wafer pattern, and determine a training loss according to the model precision evaluation index and the mask quality evaluation index.

The model precision evaluation index is used for representing a mask prediction precision of the lithographic mask generation model, and the mask quality evaluation index is used for representing a quality of the predictive mask map.

In some embodiments, for the chip layout, the mask prediction ability of the lithographic mask generation model may be measured according to the predictive mask map and the predictive wafer pattern, and the training loss is determined. The training loss refers to a difference value between the predictive mask map and the predictive wafer pattern, and the training loss may be used for indicating the precision of the lithographic mask generation model.

Step 304: Adjust at least one parameter of the lithographic mask generation model according to the training loss.

In some embodiments, the at least one parameter of the lithographic mask generation model is adjusted based on the training loss, thereby training the lithographic mask generation model. Training may be stopped until the training loss meets a condition for stopping training, to obtain the trained lithographic mask generation model. In some embodiments, the condition for stopping training includes at least one of the following: the number of model iterations reaches a set number of times, a gradient of the training loss is less than a threshold, the model precision evaluation index meets a precision threshold, the mask quality evaluation index meets a mask quality threshold, and the complexity evaluation index meets a complexity threshold.

In some embodiments, the embodiments of this disclosure use the disclosed lithographic mask data set. For example, the lithographic mask data set uses the data set disclosed in the papers "GAN-OPC: Mask Optimization with Lithography-guided Generative Adversarial Nets" and "Reverse Lithography: Neural-ILT: Migrating ILT to Neural Networks for Mask Printability and Complexity Co-optimization". The two data sets have a total of 10,271 chip layouts and corresponding mask maps. The chip layout meets the 32 nm process node and certain design rules. Optionally, the mask map in the above data sets is obtained through a reverse lithographic mask optimization algorithm.

In conclusion, according to the technical solutions provided in the embodiments of this disclosure, in the process of training the lithographic mask generation model, the predictive wafer pattern is generated by the pre-trained machine learning model constructed based on a neural network, and the training loss is determined based on the generated predictive wafer pattern to update the parameter of the lithographic mask generation model, because a neural network model is adopted to generate the predictive wafer pattern, compared with the use of the lithographic physical model to generate the predictive wafer pattern, the amount of computation required is less and the calculation efficiency is higher. Therefore, the embodiments of this disclosure save the time required to generate the predictive wafer pattern, thereby improving the training efficiency of the lithographic mask generation model.

It is to be illustrated that on the one hand, because a machine learning model constructed based on a neural network adopted by the predictive wafer pattern is pre-trained, the training process of the lithographic mask generation model does not contain the training process of the wafer pattern generation model, which saves the time required to generate the predictive wafer pattern, thereby saving the time required to train the lithographic mask generation model, and improving the training efficiency of the lithographic mask generation model. On the other hand, for training the wafer pattern generation model, it is only necessary to generate the standard wafer patterns respectively corresponding to the mask map samples for a small number of mask map samples through the lithographic physical model, and then the pre-trained wafer pattern generation model participates in the process of lithographic mask generation model, and the lithographic physical model does not need to participate. In response to using the lithographic physical model to generate the predictive wafer pattern, because the predictive mask map generated by the lithographic mask generation model is different for each round, the lithographic physical model needs to generate a corresponding wafer pattern for the predictive mask map generated by the lithographic physical model each round. In this case, the number of wafer patterns that need to be generated based on the lithographic physical model may be significantly increased, thereby increasing the time required to train the lithographic mask generation model and reducing the training efficiency of the lithographic mask generation model.

For example, taking an annotation data set adopted to train the lithographic mask generation model including 10,000 chip layouts with annotations, and the training round of the lithographic mask generation model being 100 (that is, 100 iterations) as an example, in response to using the lithographic physical model to generate the predictive wafer pattern, for each chip layout, each round may generate a predictive mask map based on the lithographic mask generation model, and each predictive mask map needs to generate a wafer pattern based on the lithographic physical model, and therefore, $10,000 \times 100$ wafer patterns are generated by the lithographic physical model. In response to first pre-training the wafer pattern generation model, and then using the pre-trained wafer pattern generation model to generate a predictive wafer pattern corresponding to the predictive mask map, in the training process of the wafer pattern generation model, the corresponding annotation data set also have 10,000 annotation data, that is, the annotation data set adopted to train the wafer pattern generation model includes 10,000 mask maps with annotation. That is, it is at most necessary to generate the wafer patterns corresponding to these 10,000 mask maps by the lithographic physical model, to obtain the pre-trained wafer pattern generation model. It is obvious that the predictive wafer pattern corresponding to the predictive mask map is generated by the pre-trained wafer pattern generation model, and on this basis, the lithographic mask generation model is trained. The number of wafer patterns generated by the lithographic physical generation model is much smaller than the number of wafer patterns generated by the lithographic physical model in the method for generating the predictive wafer pattern using the lithographic physical model (that is, 10,000 is much smaller than $10,000 \times 100$), which saves the time required to generate the predictive wafer pattern, thereby improving the training efficiency of the lithographic mask generation model.

In some possible implementations, as shown in FIG. 4, step 303 further includes the following steps (3031-3033): Step 3031: Calculate the model precision evaluation index according to a difference between the predictive mask map and a standard mask map corresponding to the chip layout, the model precision evaluation index being used for representing a mask prediction precision of the lithographic mask generation model.

In some embodiments, the model precision evaluation index is generated based on an absolute difference between the predictive mask map and the standard mask map belonging to a same group, or the model precision evaluation index is generated based on an absolute percentage difference between the predictive mask map and the standard mask map belonging to the same group, or the model precision evaluation index is generated based on a median absolute difference between the predictive mask map and the standard mask map belonging to the same group, but is not limited thereto, which is not specifically limited in the embodiments of this disclosure.

The absolute percentage difference is a percentage of the absolute difference between the predictive mask map and the standard mask map and the standard mask map.

The median absolute difference is a median between a plurality of absolute differences between the predictive mask map and the standard mask map.

In some embodiments, for the chip layout inputted in the lithographic mask generation model, the mask prediction precision of the lithographic mask generation model may be measured by calculating a difference between the predictive mask map and the high-quality standard mask map, that is, the mask prediction ability of the lithographic mask generation model may be measured. The smaller the difference between the predictive mask map and the standard mask map is, the higher the mask prediction precision of the lithographic mask generation model is. On the contrary, the greater the difference between the predictive mask map and the standard mask map is, the lower the mask prediction precision of the lithographic mask generation model is.

Step 3032: Calculate the mask quality evaluation index according to a difference between the predictive wafer pattern and the chip layout, the mask quality evaluation index being used for representing a quality of the predictive mask map.

In some embodiments, the smaller the difference between the predictive wafer pattern and the corresponding chip layout is, the higher the quality of the corresponding predictive mask map is. On the contrary, the greater the difference between the predictive wafer pattern and the corresponding chip layout is, the lower the quality of the corresponding predictive mask map is.

In some embodiments, the generation of the mask quality evaluation index includes subjective evaluation generation and objective evaluation generation.

Subjective evaluation refers to the evaluation of the difference between the predictive wafer pattern and the corresponding chip layout based on a viewer's subjective perception.

Objective evaluation refers to an objective comparison based on image features of the predictive wafer pattern and the chip layout, so as to obtain the difference between the predictive wafer pattern and the corresponding chip layout.

Step 3033: Determine a training loss according to the model precision evaluation index and the mask quality evaluation index.

In some embodiments, the training loss is obtained by summing (such as weighted summing) values corresponding to the model precision evaluation index and the mask quality evaluation index.

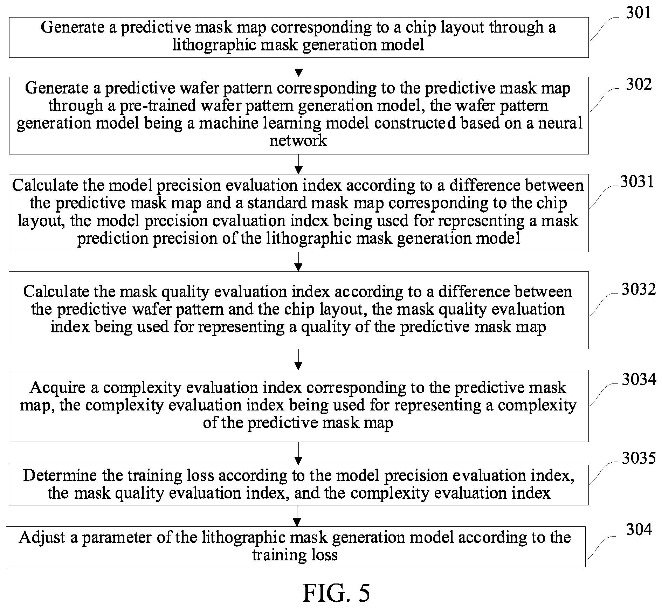

In some embodiments, as shown in FIG. 5, the method further includes the following steps (3034-3035):

Step 3034: Acquire a complexity evaluation index corresponding to the predictive mask map, the complexity evaluation index being used for representing a complexity of the predictive mask map.

By adding the complexity evaluation index to the training loss, the lithographic mask generation model tends to generate a predictive mask map with low complexity, so as to reduce the complexity of the predictive mask map generated by the lithographic mask generation model, thereby improving the manufacturability of the predictive mask map.

In some embodiments, if there are many tiny structures (such as holes, protrusions, and saw teeth) that are easily exposed to the wafer in the predictive mask map, the complexity of the predictive mask map is higher. If there is no or less tiny structures (such as holes, protrusions, and sawteeth) that are less easily exposed to the wafer in the predictive mask map, the complexity of the predictive mask map is higher.

In some embodiments, the method further includes the following steps (1-2):

1. Generate a plurality of wafer patterns corresponding to the predictive mask map by using a first lithographic physical model based on a plurality of different process parameters, the first lithographic physical model being a mathematical physical simulation model based on the principle of optics.

In some embodiments, the mask patterns of the predictive mask map corresponding to a plurality of different process parameters are generated, and there are two or more types of process parameters. The process parameters include exposure, defocusing, and so on. Optionally, the types of process parameters and the values of specific process parameters may be set by the relevant technical personnel according to actual situations, which is not specifically limited in the embodiments of this disclosure.

In some embodiments, a first wafer pattern corresponding to the predictive mask map is generated by using the first lithographic physical model based on a first process parameter. A second wafer pattern corresponding to the predictive mask map is generated by using the first lithographic physical model based on a second process parameter. An exposure of the first process parameter is less than an exposure of the second process parameter, and a defocusing of the first process parameter is less than a defocusing of the second process parameter.

2. Determine, according to a difference between the plurality of wafer patterns, a complexity evaluation index corresponding to the predictive mask map.

The simpler the predictive mask map is (that is, the complexity is lower), the smaller the difference between the wafer patterns obtained under different process parameters is. The more complex the predictive mask map is, the greater the difference between the wafer patterns obtained under different process parameters is. Therefore, the smaller the difference between a plurality of wafer patterns is, the lower (i.e., simpler) the complexity the corresponding predictive mask map is. The greater the difference between the plurality of wafer patterns is, the more complex the corresponding predictive mask map is. Therefore, the complexity of the predictive mask map may be easily and intuitively measured through the difference of wafer patterns obtained under different process parameters. For each predictive mask map, a wafer pattern corresponding to the predictive mask map needs to be generated based on each set of process parameters. There are 2 sets (i.e., each predictive mask map corresponds to 2 wafer patterns), 3 sets (i.e., each predictive mask map corresponds to 3 wafer patterns), 4 sets (i.e., each predictive mask map corresponds to 4 wafer patterns), 5 sets (i.e., each predictive mask map corresponds to 5 wafer patterns), etc. of process parameters, which is not specifically limited in the embodiments of this disclosure.

In some embodiments, the complexity evaluation index corresponding to the predictive mask map is calculated according to a difference between the first wafer pattern and the second wafer pattern. That is, for each predictive mask map, only two wafer patterns corresponding to different process parameters are required to calculate the complexity evaluation index, which reduces the calculation amount and time required to calculate the complexity evaluation index compared with calculation of the complexity evaluation index by using 3, 4, 5 or more wafer patterns, thereby improving the training efficiency of the lithographic mask generation model.

In some embodiments, the complexity evaluation index is generated through an average difference value of pattern differences between any two wafer patterns, or, the complexity evaluation index is generated through a difference value percentage of pattern differences between any two wafer patterns, or the complexity evaluation index is generated through a median difference value of pattern differences between any two wafer patterns, but is not limited thereto, which is not specifically limited in the embodiments of this disclosure.

The average difference value is an average value of the pattern difference values between any two wafer patterns.

The difference value percentage is a percentage of difference values in the pattern difference values between any two wafer patterns greater than the threshold.

The median difference value is a median between a plurality of pattern difference values between any two wafer patterns.

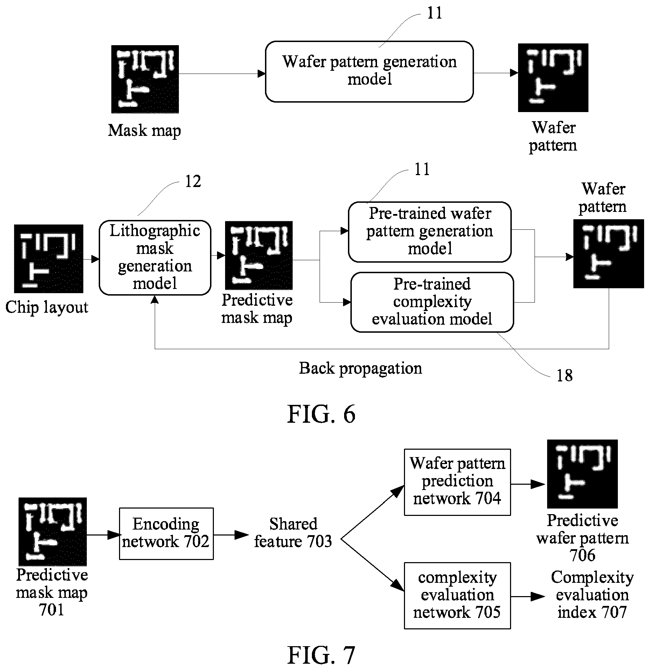

In some embodiments, as shown in FIG. 6, the complexity evaluation index corresponding to the predictive mask map is generated through a pre-trained complexity evaluation model 18. The complexity evaluation model 18 is a neural network-based machine learning model. That is, after the mask map is inputted into the complexity evaluation model, the complexity evaluation model may output the complexity evaluation index corresponding to the mask map.

In some embodiments, the complexity evaluation index corresponding to the predictive mask map is directly outputted by the complexity evaluation model. The specific method includes: acquiring a second data set, the second data set including at least one mask map sample, and a standard complexity evaluation index corresponding to the mask map sample; and training the complexity evaluation model by using the second data set, to obtain the pre-trained complexity evaluation model.

Similar to the generation of the predictive wafer pattern by using the pre-trained wafer pattern generation model, on the one hand, the complexity evaluation index corresponding to the predictive mask map is directly outputted by the complexity evaluation model. In this way, there is no need to generate the mask map based on the lithographic physical model during the training process of the lithographic physical model, so as to save the computing resources and the computing time, further improving the training efficiency of the lithographic mask generation model. On the other hand, in response to using the lithographic physical model to generate the predictive wafer pattern corresponding to the predictive mask map and determining the complexity evaluation index of the predictive mask map based on the predictive wafer pattern, because the predictive mask map generated by the lithographic mask generation model is different for each round, the lithographic physical model needs to generate a corresponding wafer pattern for the predictive mask map generated by the lithographic physical model each round. In this case, the number of wafer patterns that need to be generated based on the lithographic physical model may be significantly increased, thereby increasing the time required to train the lithographic mask generation model and reducing the training efficiency of the lithographic mask generation model. Moreover, for training the complexity evaluation model, it is only necessary to generate the standard wafer patterns respectively corresponding to the mask map samples for a small number of mask map samples through the lithographic physical model, and then the pre-trained wafer pattern generation model participates in the process of lithographic mask generation model, and the lithographic physical model does not need to participate, which saves the time required to generate the wafer pattern, thereby improving the training efficiency of the lithographic mask generation model.

In some embodiments, a plurality of wafer patterns (such as the first wafer pattern and the second wafer pattern) corresponding to the predictive mask map under different process parameters are generated by the wafer pattern generation model, and then the complexity evaluation index corresponding to the predictive mask map is determined according to the difference between the plurality of wafer patterns. In this way, compared with using the lithographic physical model to generate a plurality of wafer patterns corresponding to the predictive mask map, and determining the complexity evaluation index of the predictive mask map based on the plurality of wafer patterns, the time required to generate the wafer patterns may also be saved, thereby improving the training efficiency of the lithographic mask generation model. However, compared with using an end-to-end complexity index generation model, a corresponding complexity evaluation index may be directly outputted after the predictive mask map is inputted, and the time required to determine the complexity evaluation index corresponding to the predictive mask map may be increased because the wafer pattern still needs to be generated.

In some embodiments, the wafer pattern generation model and the complexity evaluation model are machine learning models based on a neural network. The wafer pattern generation model and the complexity evaluation model share a same feature extraction network. The wafer pattern generation model includes the feature extraction network and a wafer pattern prediction network, and the complexity evaluation model includes the feature extraction network and a complexity evaluation network. In some embodiments, feature information corresponding to the predictive mask map obtained by the feature extraction network is processed by the complexity evaluation network, to obtain the complexity evaluation index corresponding to the predictive mask map.

In some embodiments, the wafer pattern generation model and the complexity evaluation model may share an encoding network or a part of the encoding network, and the shared part of the encoding network is the same feature extraction network described above. For the predictive mask map generated by the lithographic mask generation model, the wafer pattern generation model and the complexity evaluation model share the same feature extraction network for feature extraction to obtain a shared feature, and then the shared feature is inputted into the wafer pattern prediction network and the complexity evaluation network respectively, the predictive wafer pattern of the predictive mask map is outputted by the wafer pattern prediction network, and the complexity evaluation index corresponding to the predictive mask map is outputted by the complexity evaluation network.

In this way, the wafer pattern generation model and the complexity evaluation model share the feature extraction network to reduce a storage space occupied by the two models, and save the total processing resources and time required for the operation of the two models, thereby further improving the training efficiency of the lithographic mask generation model.

Exemplarily, FIG. 7 illustrates a schematic diagram showing that the wafer pattern generation model and the complexity evaluation model share the feature extraction network. The wafer pattern generation model and the complexity evaluation model share an encoding network 702. The encoding network 702 refers to the same feature extraction network in the wafer pattern generation model and the complexity evaluation model. A predictive mask map 701 is inputted to the encoding network 702 for feature extraction to obtain a shared feature 703 shared by the wafer pattern generation model and the complexity evaluation model. The shared feature 703 is inputted to the wafer pattern prediction network 704 for generation of the wafer pattern, to obtain a predictive wafer pattern 706 corresponding to the predictive mask map 701. The shared feature 703 is inputted to the complexity evaluation model 705 to output a complexity evaluation index 707 corresponding to the predictive mask map 701.

Step 3035: Determine the training loss according to the model precision evaluation index, the mask quality evaluation index, and the complexity evaluation index.

In some embodiments, the training loss is obtained by summing (such as weighted summing) the model precision evaluation index, the mask quality evaluation index, and the complexity evaluation index.

In some embodiments, subtraction is performed on matrices respectively corresponding to the first wafer pattern and the second wafer pattern, to obtain a first difference matrix. A determinant corresponding to the first difference matrix is squared to obtain the complexity evaluation index corresponding to the predictive mask map.

In some embodiments, the calculation of the training loss may refer to the following formula:

$$L = L_{fit} + \alpha * L_{target-wafer} + \beta * L_{complex}$$

$$= \left|Mask_{pred} - Mask\right|^2 + \alpha * \left|Wafer_{pred} - Target\right|^2 + \beta$$

$$* \left|Lith(Mask_{pred}, P_{min}) - Lith(Mask_{pred}, P_{max})\right|^2$$

L Represents the training loss, $L_{fit}$ represents the model precision evaluation index, $L_{target-wafer}$ represents the mask quality evaluation index, $L_{complex}$ represents the complexity evaluation index corresponding to the predictive mask map, $\alpha$ and $\beta$ are adjustable parameters, Mask represents the standard mask map, $Mask_{pred}$ represents the predictive mask map, $Wafer_{pred}$ represents the predictive wafer pattern, and Target represents the chip layout.

$Lith(Mask_{pred}, P_{min})$ represents a wafer pattern (such as a first wafer pattern) obtained under the process conditions of low exposure and low defocusing. In some embodiments, the low exposure refers to 98% of the normal exposure, and the low defocusing refers to 25 nm defocusing. $Lith(Mask_{pred}, P_{max})$ represents a wafer pattern (such as a second wafer pattern) obtained under the process conditions of high exposure and no defocusing. In some embodiments, the high exposure refers to 102% of the normal exposure. Under the process conditions of low exposure and low defocusing, many tiny structures (such as holes, protrusions, and sawteeth) in the mask map are not exposed on the wafer, that is, the tiny structures in the mask map may not or rarely appear on the first wafer pattern. Under the process conditions of high exposure and no defocusing, in a case that there are many tiny structures in the mask map, these tiny structures are exposed on the wafer, that is, most or all the tiny structures in the mask map appear on the second wafer pattern. Therefore, smaller difference between $Lith(Mask_{pred}, P_{min})$ and $Lith(Mask_{pred}, P_{max})$ means that many tiny structures in the predictive mask map may not generate, that is, the complexity of the predictive mask map is also lower.

In some embodiments, the specific values corresponding to the low exposure, the low defocusing, and the high exposure are not limited to the above examples, and may be set by the relevant technical personnel according to actual situations, which are not specifically limited in the embodiments of this disclosure.

In some embodiments, the training loss is minimized through a gradient descent algorithm, and a gradient of the training loss is defined as follows:

$$\frac{\partial L}{\partial w} = \frac{\partial L_{fit}}{\partial w} + \alpha \times \frac{\partial L_{target-wafer}}{\partial w} + \beta \times \frac{\partial L_{complex}}{\partial w}$$

$$= \frac{\partial L_{fit}}{\partial w} + \alpha \times \frac{\partial L_{target-wafer}}{\partial w} + \beta \times \frac{\partial L_{complex}}{\partial Mask_{pred}} \times \frac{\partial Mask_{pred}}{\partial w}$$

$$\frac{\partial L_{complex}}{\partial Mask_{pred}} = 2 \times (Z_{min} - Z_{max}) \odot (Z'_{min} - Z'_{max})$$

$$Z_{min} = sig(I) = \frac{1}{1 + \exp(-\theta_Z \times (I - I_{th}))}$$

$$I(x, y) = \sum_{k=1}^{K} \omega_k |Mask_{pred}(x, y) \otimes h_{defocus_k}(x, y)|^2$$

$$Z'_{min} = \theta_M \times \theta_Z \times \{H_{defocus}^{flip} \otimes [Z_{min} \odot (1 - Z_{min}) \odot (M \otimes H_{defocus}{}^*)] + \left(H_{defocus}^{flip}\right)^* \otimes [Z_{min} \odot (1 - Z_{min}) \odot (M \otimes H_{defocus})]\} \odot M \odot (1 - M)$$

L represents the training loss, $L_{fit}$ represents the model precision evaluation index, $L_{target\text{-}wafer}$ represents the mask quality evaluation index, $L_{complex}$ represents the complexity evaluation index corresponding to the predictive mask map, $\alpha$ and $\beta$ are adjustable parameters, $Mask_{pred}$ represents the predictive mask map, Z is the light intensity distribution value imaged on the wafer, $Z_{min}$ represents the light intensity distribution value under the low exposure condition, $Z'_{min}$ represents the light intensity distribution value under the low defocusing process condition, $Z_{max}$ represents the light intensity distribution value under the high exposure condition, $Z'_{max}$ represents the light intensity distribution value under the high defocusing process condition, I represents the light intensity distribution imaged on the lithographic physical model, sig represents variance analysis, w represents the weight of neurons in the lithographic mask generation model, $\theta_Z$ is a constant and the value may be 50, the value of $I_{th}$ may be 0.225, $h_{defocus_k}$ and $\omega_k$ represent the kernel function of the $k^{th}$ defocusing lithographic system and the corresponding weight coefficient, respectively. K may be 24. $H_{defocus}{}^*$ is the complex conjugate of the kernel function $H_{defocus}$ of the defocusing lithographic system, $H_{defocus}^{flip}$ is obtained by flipping $H_{defocus}$ 180°, $\otimes$ represents the matrix convolution operation, $\odot$ represents the multiplication of corresponding elements of the matrix, M represents the mask, $M = \dfrac{1}{1 + exp(-\theta_M \times Mask_{pred})}$ , and exp is the exponential function, where $\theta_M$ is a constant, and $\theta_M$ may be 4.

In the above implementation, the training loss is determined by the model precision evaluation index and the mask quality evaluation index, and on this basis, the lithographic mask generation model is trained, which may improve the model precision of the lithographic mask generation model and the quality of the generated predictive mask map.

In addition, by adding the complexity evaluation index to the training loss, the lithographic mask generation model tends to generate a predictive mask map with low complexity, so as to reduce the complexity of the predictive mask map generated by the lithographic mask generation model, thereby improving the manufacturability of the predictive mask map.

The following describes apparatus embodiments of this disclosure, which may be used for executing the method embodiments of this disclosure. For details that are not disclosed in the apparatus embodiments of this disclosure, refer to the method embodiments of this disclosure.

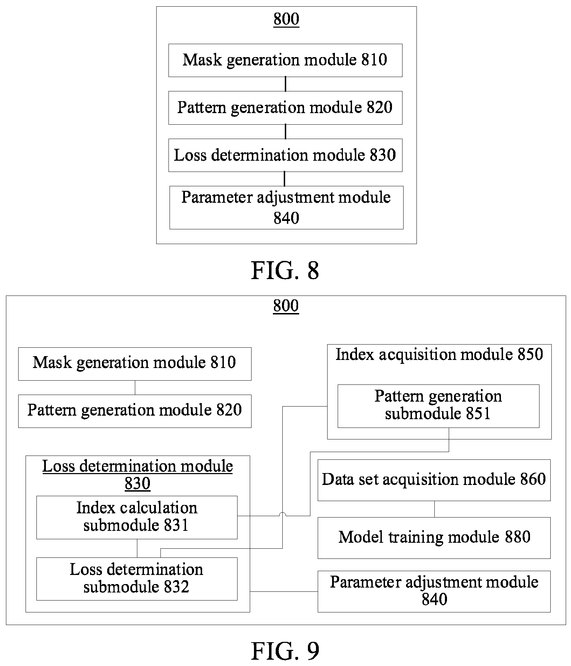

FIG. 8 illustrates a block diagram of a training apparatus for a lithographic mask generation model according to an embodiment of this disclosure. The apparatus has a function for implementing the foregoing training method embodiments for the lithographic mask generation model, and the function may be implemented by hardware or may be implemented by hardware executing corresponding software. The apparatus may be the model training device described above, and may also be provided on the model training device. The apparatus 800 may include: a mask generation module 810, a pattern generation module 820, a loss determination module 830, and a parameter adjustment module 840.

The mask generation module 810 is configured to generate a predictive mask map corresponding to a chip layout through a lithographic mask generation model. The lithographic mask generation model is a neural network model for generating the predictive mask map.

The pattern generation module 820 is configured to generate a predictive wafer pattern corresponding to the predictive mask map through a pre-trained wafer pattern generation model. The wafer pattern generation model is a neural network-based machine learning model.

The loss determination module 830 is configured to determine a model precision evaluation index according to the predictive mask map, and determine a mask quality evaluation index according to the predictive wafer pattern. The model precision evaluation index is used for representing a mask prediction precision of the lithographic mask generation model, and the mask quality evaluation index is used for representing a quality of the predictive mask map. A training loss is determined according to the model precision evaluation index and the mask quality evaluation index.

The parameter adjustment module 840 is configured to adjust at least one parameter of the lithographic mask generation model according to the training loss.

In some embodiments, as shown in FIG. 9, the loss determination module 830 includes: an index calculation submodule 831 and a loss determination submodule 832.

The index calculation submodule 831 is configured to calculate the model precision evaluation index according to a difference between the predictive mask map and a standard mask map corresponding to the chip layout.

The index calculation submodule 831 is further configured to calculate the mask quality evaluation index according to a difference between the predictive wafer pattern and the chip layout.

The loss determination submodule 832 is configured to determine the training loss according to the model precision evaluation index and the mask quality evaluation index.

In some embodiments, as shown in FIG. 9, the apparatus 800 further includes: an index acquisition module 850.

The index acquisition module 850 is configured to acquire a complexity evaluation index corresponding to the predictive mask map. The complexity evaluation index is used for representing a complexity of the predictive mask map.

The loss determination submodule 832 is configured to determine the training loss according to the model precision evaluation index, the mask quality evaluation index, and the complexity evaluation index.

In some embodiments, as shown in FIG. 9, the index acquisition module 850 includes: a pattern generation submodule 851.

The pattern generation submodule 851 is configured to generate a plurality of wafer patterns corresponding to the predictive mask map by using a first lithographic physical model based on a plurality of different process parameters. The first lithographic physical model is a mathematical physical simulation model based on the principle of optics.

The index calculation submodule 831 is configured to determine, according to a difference between the plurality of wafer patterns, the complexity evaluation index corresponding to the predictive mask map.

In some embodiments, as shown in FIG. 9, the pattern generation submodule 851 is configured to:

generate a first wafer pattern corresponding to the predictive mask map by using the first lithographic physical model based on a first process parameter; and

generate a second wafer pattern corresponding to the predictive mask map by using the first lithographic physical model based on a second process parameter. An exposure of the first process parameter is less than an exposure of the second process parameter, and a defocusing of the first process parameter is less than a defocusing of the second process parameter.

The index calculation submodule 831 is further configured to calculate, according to a difference between the first wafer pattern and the second wafer pattern, the complexity evaluation index corresponding to the predictive mask map.

In some embodiments, as shown in FIG. 9, the index calculation submodule 831 is configured to:

perform subtraction on matrices respectively corresponding to the first wafer pattern and the second wafer pattern, to obtain a first difference matrix; and

square a determinant corresponding to the first difference matrix to obtain the complexity evaluation index corresponding to the predictive mask map.

In some embodiments, as shown in FIG. 9, the index acquisition module 850 is configured to generate the complexity evaluation index corresponding to the predictive mask map through a pre-trained complexity evaluation model. The complexity evaluation model is a neural network-based machine learning model.

In some embodiments, as shown in FIG. 9, the apparatus 800 further includes: a data set acquisition module 860 and a model training module 870.

The data set acquisition module 860 is configured to acquire a second data set. The second data set includes at least one mask map sample, and a standard complexity evaluation index corresponding to the mask map sample.

The model training module 870 is configured to train the complexity evaluation model by using the second data set, to obtain the pre-trained complexity evaluation model.

In some embodiments, the wafer pattern generation model and the complexity evaluation model share a same feature extraction network, the wafer pattern generation model includes the feature extraction network and a wafer pattern prediction network, and the complexity evaluation model includes the feature extraction network and a complexity evaluation network. As shown in FIG. 9, the index acquisition module 850 is configured to process, through the complexity evaluation network, feature information corresponding to the predictive mask map obtained by the feature extraction network, to obtain the complexity evaluation index corresponding to the predictive mask map.

In some embodiments, as shown in FIG. 9, the data set acquisition module 860 is further configured to obtain a first data set. The first data set includes at least one mask map sample, and a standard wafer pattern corresponding to the mask map sample.

The model training module 870 is further configured to train the wafer pattern generation model by using the first data set, to obtain the pre-trained wafer pattern generation model.

In some embodiments, as shown in FIG. 9, the data set acquisition module 860 is configured to:

perform optical proximity correction (OPC) processing on a chip layout sample, to obtain a mask map sample corresponding to the chip layout sample;

obtain a standard wafer pattern corresponding to the mask map sample through a second lithographic physical model, the second lithographic physical model being a mathematical physical simulation model based on the principle of optics; and

construct the first data set according to the mask map sample and the standard wafer pattern that have a corresponding relationship.

In conclusion, according to the technical solutions provided in the embodiments of this disclosure, in the process of training the lithographic mask generation model, the predictive wafer pattern is generated by the pre-trained machine learning model constructed based on a neural network, and the training loss is determined based on the generated predictive wafer pattern to update the parameter of the lithographic mask generation model, because a neural network model is adopted to generate the predictive wafer pattern, compared with the use of the lithographic physical model to generate the predictive wafer pattern, the amount of computation required is less and the calculation efficiency is higher. Therefore, the embodiments of this disclosure save the time required to generate the predictive wafer pattern, thereby improving the training efficiency of the lithographic mask generation model.

It is to be illustrated that in a case that the apparatus provided in the foregoing embodiments implements the functions thereof, only division of the foregoing functional modules is used as an example for description. In the practical application, the functions may be allocated to and completed by different functional modules according to requirements. That is, an internal structure of the device is divided into different functional modules, to complete all or some of the functions described above. In addition, the apparatus provided in the foregoing embodiments and the method embodiments fall within a same conception. For details of a specific implementation process, refer to the method embodiments. Details are not described herein again.

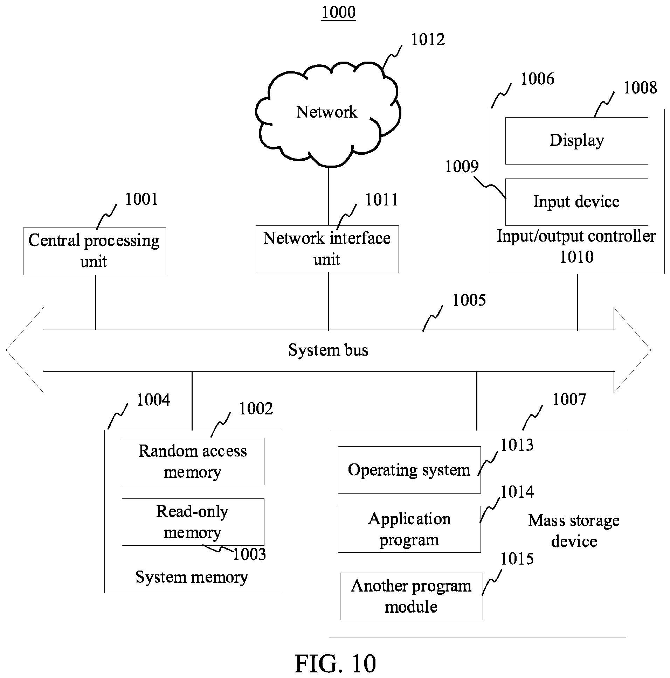

FIG. 10 illustrates a structural block diagram of a computer device according to an embodiment of this disclosure. The computer device is configured to perform the training method for a lithographic mask generation model provided in the foregoing embodiments. Specifically,

The computer device 1000 includes a CPU 1001, a system memory 1004 including a random access memory (RAM) 1002 and a read-only memory (ROM) 1003, and a system bus 1005 connecting the system memory 1004 to the CPU 1001. The computer device 1000 further includes a basic input/output (I/O) system 1006 assisting in transmitting information between components in the computer, and a mass storage device 1007 configured to store an operating system 1013, an application program 1014, and another program module 1015.

The basic I/O system 1006 includes a display 1008 configured to display information and an input device 1009, such as a mouse or a keyboard, configured to input information by a user. The display 1008 and the input device 1009 are coupled to the CPU 1001 through an I/O controller 1010 coupled to the system bus 1005. The basic I/O system 1006 may further include the I/O controller 1010 to be configured to receive and process inputs from a plurality of other devices such as a keyboard, a mouse, and an electronic stylus. Similarly, the I/O controller 1010 further provides an output to a display screen, a printer, or another type of output device.

The mass storage device 1007 is coupled to the CPU 1001 through a mass storage controller (not shown) coupled to the system bus 1005. The mass storage device 1007 and a computer readable medium associated therewith provide non-volatile storage to the computer device 1000. That is, the mass storage device 1007 may include a computer readable medium (not shown) such as a hard disk or a compact disc Compact Disc Read-Only Memory (CD-ROM) drive.

Generally, the computer readable medium may include a computer storage medium and a communication medium. The computer storage medium includes volatile and non-volatile, removable and non-removable media that store information such as computer readable instructions, data structures, program modules, or other data and that are implemented by using any method or technology. The computer storage medium includes a RAM, a ROM, an erasable programmable read only memory (EPROM), an electrically erasable programmable read only memory (EEPROM), a flash memory or another solid-state memory technology, a CD-ROM, a digital versatile disc (DVD) or another optical memory, a tape cartridge, a magnetic cassette, a magnetic disk memory, or another magnetic storage device. Certainly, a person skilled in art may know that the computer storage medium is not limited to the foregoing several types. The system memory 1004 and the mass storage device 1007 may be collectively referred to as a memory.

According to the embodiments of this disclosure, the computer device 1000 may further be coupled, through a network such as the Internet, to a remote computer on the network and run. That is, the computer device 1000 may be coupled to a network 1012 by using a network interface unit 1011 coupled to the system bus 1005, or may be coupled to another type of network or a remote computer system (not shown) by using a network interface unit 1011.

An exemplary embodiment further provides a computer readable storage medium including at least one segment of a program. The t least one segment of the program is executed by a processor to implement the foregoing training method for a lithographic mask generation model.

Optionally, the computer readable storage medium may include: a read-only memory (ROM), a random-access memory (RAM), a solid state drive (SSD), an optical disc, or the like. The random-access memory may include a resistance random access memory (ReRAM) and a dynamic random access memory (DRAM).

An exemplary embodiment further provides a computer program product or a computer program, including computer instructions stored in a computer readable storage medium. A processor of the computer device reads the computer instruction from the computer readable storage medium. The processor executes the computer instruction, so that the computer device executes the training method for a lithographic mask generation model.

**Claims**

1. A training method for a lithographic mask generation model (12), the method being executed by a computer device, the method comprising:

   generating (301) a predictive mask map corresponding to a chip layout through a lithographic mask generation model (12), the lithographic mask generation model (12) being a neural network model for generating the predictive mask map;
   generating (302) a predictive wafer pattern corresponding to the predictive mask map through a pre-trained wafer pattern generation model (11), the wafer pattern generation model (11) being a neural network-based machine learning model;
   determining (303) a model precision evaluation index according to the predictive mask map, and determining (303) a mask quality evaluation index according to the predictive wafer pattern, the model precision evaluation index being used for representing a mask prediction precision of the lithographic mask generation model (12), and the mask quality evaluation index being used for representing a quality of the predictive mask map;
   determining (303) a training loss according to the model precision evaluation index and the mask quality evaluation index; and
   adjusting (304) at least one parameter of the lithographic mask generation model (12) according to the training loss.

2. The method according to claim 1, wherein determining (303) the model precision evaluation index according to the predictive mask map, and determining (303) the mask quality evaluation index according to the predictive wafer pattern comprises:

   calculating (3031) the model precision evaluation index according to a difference between the predictive mask map and a standard mask map corresponding to the chip layout; and
   calculating (3032) the mask quality evaluation index according to a difference between the predictive wafer pattern and the chip layout.

3. The method according to claim 1 or 2, further comprising:

   acquiring (3034) a complexity evaluation index corresponding to the predictive mask map, the complexity evaluation index representing a complexity of the predictive mask map; and
   determining (303) the training loss according to the model precision evaluation index and the mask quality evaluation index comprises:
   determining (3035) the training loss according to the model precision evaluation index, the mask quality evaluation index, and the complexity evaluation index.

4. The method according to claim 3, wherein acquiring (3034) the complexity evaluation index corresponding to the predictive mask map comprises:

   generating a plurality of wafer patterns corresponding to the predictive mask map by using a first lithographic physical model based on a plurality of different process parameters, the first lithographic physical model being a mathematical physical simulation model based on a principle of optics; and
   determining, according to a difference between the plurality of wafer patterns, the complexity evaluation index corresponding to the predictive mask map.

5.  The method according to claim 4, wherein generating the plurality of wafer patterns corresponding to the predictive mask map by using the first lithographic physical model based on the plurality of different process parameters comprises;

    generating a first wafer pattern corresponding to the predictive mask map by using the first lithographic physical model based on a first process parameter; and
    generating a second wafer pattern corresponding to the predictive mask map by using the first lithographic physical model based on a second process parameter, wherein an exposure of the first process parameter is less than an exposure of the second process parameter, and a defocusing of the first process parameter is less than a defocusing of the second process parameter; and
    determining, according to the difference between the plurality of wafer patterns, the complexity evaluation index corresponding to the predictive mask map comprises:
    calculating, according to a difference between the first wafer pattern and the second wafer pattern, the complexity evaluation index corresponding to the predictive mask map.

6.  The method according to claim 5, wherein calculating, according to the difference between the first wafer pattern and the second wafer pattern, the complexity evaluation index corresponding to the predictive mask map comprises:

    performing subtraction on matrices respectively corresponding to the first wafer pattern and the second wafer pattern to obtain a first difference matrix; and
    squaring a determinant corresponding to the first difference matrix to obtain the complexity evaluation index corresponding to the predictive mask map.

7.  The method according to claim 3, wherein acquiring (3034) the complexity evaluation index corresponding to the predictive mask map comprises:
    generating the complexity evaluation index corresponding to the predictive mask map through a pre-trained complexity evaluation model (18), wherein the complexity evaluation model is a neural network-based machine learning model.

8.  The method according to claim 7, further comprising:

    acquiring a second data set, the second data set comprising at least one mask map sample, and a standard complexity evaluation index corresponding to the mask map sample; and
    training the complexity evaluation model by using the second data set to obtain the pre-trained complexity evaluation model (18).

9.  The method according to claim 7, wherein the wafer pattern generation model (11) and the complexity evaluation model share a same feature extraction network, the wafer pattern generation model (11) comprises the feature extraction network and a wafer pattern prediction network, and the complexity evaluation model comprises the feature extraction network and a complexity evaluation network; and
    generating the complexity evaluation index corresponding to the predictive mask map through the pre-trained complexity evaluation model (18) comprises:
    processing, through the complexity evaluation network, feature information corresponding to the predictive mask map obtained by the feature extraction network, to obtain the complexity evaluation index corresponding to the predictive mask map.

10. The method according to any one of claims 1 to 9, further comprising:

    acquiring a first data set, the first data set comprising at least one mask map sample, and a standard wafer pattern corresponding to the mask map sample; and
    training the wafer pattern generation model (11) by using the first data set to obtain the pre-trained wafer pattern generation model (11).

11. The method according to claim 10, wherein acquiring the first data set comprises:

    performing optical proximity correction, OPC, processing on a chip layout sample, to obtain a mask map sample corresponding to the chip layout sample;

obtaining a standard wafer pattern corresponding to the mask map sample through a second lithographic physical model, the second lithographic physical model being a mathematical physical simulation model based on the principle of optics; and

constructing the first data set according to the mask map sample and the standard wafer pattern that have a corresponding relationship.

12. A training apparatus (800) for a lithographic mask generation model (12), **characterized by** the apparatus comprising:

a mask generation module (810), configured to generate a predictive mask map corresponding to a chip layout through a lithographic mask generation model (12), the lithographic mask generation model (12) being a neural network model for generating the predictive mask map;

a pattern generation module (820), configured to generate a predictive wafer pattern corresponding to the predictive mask map through a pre-trained wafer pattern generation model (11), the wafer pattern generation model (11) being a neural network-based machine learning model;

a loss determination module (830), configured to determine a model precision evaluation index according to the predictive mask map, and determine a mask quality evaluation index according to the predictive wafer pattern; the model precision evaluation index being used for representing a mask prediction precision of the lithographic mask generation model (12), and the mask quality evaluation index being used for representing a quality of the predictive mask map; determine a training loss according to the model precision evaluation index and the mask quality evaluation index; and

a parameter adjustment module (840), configured to adjust at least one parameter of the lithographic mask generation model (12) according to the training loss.

13. The apparatus (800) according to claim 12, wherein the loss determination module (830) comprises an index calculation submodule (831) and a loss determination submodule (832);

the index calculation submodule (831) is configured to calculate the model precision evaluation index according to a difference between the predictive mask map and a standard mask map corresponding to the chip layout;

the index calculation submodule (831) is configured to calculate the mask quality evaluation index according to a difference between the predictive wafer pattern and the chip layout; and

the loss determination submodule (832) is configured to determine the training loss according to the model precision evaluation index and the mask quality evaluation index.

14. The apparatus (800) according to claim 13, further comprising: an index acquisition module (850);

the index acquisition module (850) is configured to acquire a complexity evaluation index corresponding to the predictive mask map, the complexity evaluation index representing a complexity of the predictive mask map; and

the loss determination submodule (830) is configured to determine the training loss according to the model precision evaluation index, the mask quality evaluation index, and the complexity evaluation index.

15. A computer readable storage medium having a computer program stored therein, the computer program when executed by a computer causing the computer to perform the training method for a lithographic mask generation model (12) according to any one of claims 1 to 11.


**Patentansprüche**

1. Ein Trainingsverfahren für ein lithographisches Maskenerzeugungsmodell (12), wobei das Verfahren durch eine Computervorrichtung ausgeführt wird, wobei das Verfahren umfasst:

Erzeugen (301) einer prädiktiven Maskenkarte, die einem Chiplayout entspricht, durch ein lithographisches Maskenerzeugungsmodell (12), wobei das lithographische Maskenerzeugungsmodell (12) ein neuronales Netzwerkmodell zum Erzeugen der prädiktiven Maskenkarte ist;

Erzeugen (302) eines prädiktiven Wafermusters, das der prädiktiven Maskenkarte entspricht, durch ein vortrainiertes Wafermustererzeugungsmodell (11), wobei das Wafermustererzeugungsmodell (11) ein auf einem neuronalen Netzwerk basierendes Modell des maschinellen Lernens ist;

Bestimmen (303) eines Modellgenauigkeitsbewertungsindex gemäß der prädiktiven Maskenkarte und Bestimmen (303) eines Maskenqualitätsbewertungsindex gemäß dem prädiktiven Wafermuster, wobei der Modellgenauigkeitsbewertungsindex zum Darstellen einer Maskenvorhersagegenauigkeit des lithographischen Maskenerzeugungsmodells (12) verwendet wird und der Maskenqualitätsbewertungsindex zum Darstellen einer Qualität der prädiktiven Maskenkarte verwendet wird;
Bestimmen (303) eines Trainingsverlusts gemäß dem Modellgenauigkeitsbewertungsindex und dem Maskenqualitätsbewertungsindex; und
Anpassen (304) von mindestens einem Parameter des lithographischen Maskenerzeugungsmodells (12) gemäß dem Trainingsverlust.

2. Das Verfahren nach Anspruch 1, wobei das Bestimmen (303) des Modellgenauigkeitsbewertungsindex gemäß der prädiktiven Maskenkarte und das Bestimmen (303) des Maskenqualitätsbewertungsindex gemäß dem prädiktiven Wafermuster umfasst:

Berechnen (3031) des Modellgenauigkeitsbewertungsindex gemäß einer Differenz zwischen der prädiktiven Maskenkarte und einer dem Chiplayout entsprechenden Standardmaskenkarte; und
Berechnen (3032) des Maskenqualitätsbewertungsindex gemäß einer Differenz zwischen dem prädiktiven Wafermuster und dem Chiplayout.

3. Das Verfahren nach Anspruch 1 oder 2, ferner umfassend:

Erfassen (3034) eines der prädiktiven Maskenkarte entsprechenden Komplexitätsbewertungsindex, wobei der Komplexitätsbewertungsindex eine Komplexität der prädiktiven Maskenkarte darstellt; und
wobei das Bestimmen (303) des Trainingsverlusts gemäß dem Modellgenauigkeitsbewertungsindex und dem Maskenqualitätsbewertungsindex umfasst:
Bestimmen (3035) des Trainingsverlusts gemäß dem Modellgenauigkeitsbewertungsindex, dem Maskenqualitätsbewertungsindex und dem Komplexitätsbewertungsindex.

4. Das Verfahren nach Anspruch 3, wobei das Erfassen (3034) des der prädiktiven Maskenkarte entsprechenden Komplexitätsbewertungsindex umfasst:

Erzeugen einer Mehrzahl von Wafermustern, die der prädiktiven Maskenkarte entsprechen, unter Verwendung eines ersten lithographischen physikalischen Modells auf der Grundlage einer Mehrzahl unterschiedlicher Prozessparameter, wobei das erste lithographische physikalische Modell ein mathematisches physikalisches Simulationsmodell auf der Grundlage eines Prinzips der Optik ist; und
Bestimmen des der prädiktiven Maskenkarte entsprechenden Komplexitätsbewertungsindex gemäß einer Differenz zwischen der Mehrzahl von Wafermustern.

5. Das Verfahren nach Anspruch 4, wobei das Erzeugen der Mehrzahl von Wafermustern, die der prädiktiven Maskenkarte entsprechen, unter Verwendung des ersten lithographischen physikalischen Modells auf der Grundlage der Mehrzahl unterschiedlicher Prozessparameter umfasst;

Erzeugen eines ersten Wafermusters, das der prädiktiven Maskenkarte entspricht, unter Verwendung des ersten lithographischen physikalischen Modells auf der Grundlage eines ersten Prozessparameters; und
Erzeugen eines zweiten Wafermusters, das der prädiktiven Maskenkarte entspricht, unter Verwendung des ersten lithographischen physikalischen Modells auf der Grundlage eines zweiten Prozessparameters, wobei eine Belichtung des ersten Prozessparameters kleiner ist als eine Belichtung des zweiten Prozessparameters und eine Defokussierung des ersten Prozessparameters kleiner ist als eine Defokussierung des zweiten Prozessparameters; und
wobei das Bestimmen des der prädiktiven Maskenkarte entsprechenden Komplexitätsbewertungsindex gemäß der Differenz zwischen der Mehrzahl von Wafermustern umfasst:
Berechnen des der prädiktiven Maskenkarte entsprechenden Komplexitätsbewertungsindex gemäß einer Differenz zwischen dem ersten Wafermuster und dem zweiten Wafermuster.

6. Das Verfahren nach Anspruch 5, wobei das Berechnen des der prädiktiven Maskenkarte entsprechenden Komplexitätsbewertungsindex gemäß der Differenz zwischen dem ersten Wafermuster und dem zweiten Wafermuster umfasst:

Durchführen einer Subtraktion an Matrizen, die jeweils dem ersten Wafermuster und dem zweiten Wafermuster entsprechen, um eine erste Differenzmatrix zu erhalten; und

Quadrieren einer der ersten Differenzmatrix entsprechenden Determinante, um den der prädiktiven Maskenkarte entsprechenden Komplexitätsbewertungsindex zu erhalten.

7. Das Verfahren nach Anspruch 3, wobei das Erfassen (3034) des der prädiktiven Maskenkarte entsprechenden Komplexitätsbewertungsindex umfasst:
Erzeugen des der prädiktiven Maskenkarte entsprechenden Komplexitätsbewertungsindex durch ein vortrainiertes Komplexitätsbewertungsmodell (18), wobei das Komplexitätsbewertungsmodell ein auf einem neuronalen Netzwerk basierendes Modell des maschinellen Lernens ist.

8. Das Verfahren nach Anspruch 7, ferner umfassend:

Erfassen eines zweiten Datensatzes, wobei der zweite Datensatz mindestens ein Maskenkartenmuster und einen dem Maskenkartenmuster entsprechenden Standardkomplexitätsbewertungsindex umfasst; und
Trainieren des Komplexitätsbewertungsmodells unter Verwendung des zweiten Datensatzes, um das vortrainierte Komplexitätsbewertungsmodell (18) zu erhalten.

9. Das Verfahren nach Anspruch 7, wobei das Wafermustererzeugungsmodell (11) und das Komplexitätsbewertungsmodell ein gleiches Merkmalsextraktionsnetzwerk gemeinsam nutzen, das Wafermustererzeugungsmodell (11) das Merkmalsextraktionsnetzwerk und ein Wafermustervorhersagenetzwerk umfasst und das Komplexitätsbewertungsmodell das Merkmalsextraktionsnetzwerk und ein Komplexitätsbewertungsnetzwerk umfasst; und

wobei das Erzeugen des der prädiktiven Maskenkarte entsprechenden Komplexitätsbewertungsindex durch das vortrainierte Komplexitätsbewertungsmodell (18) umfasst:
Verarbeiten, durch das Komplexitätsbewertungsnetzwerk, von der prädiktiven Maskenkarte entsprechenden Merkmalsinformationen, die durch das Merkmalsextraktionsnetzwerk erhalten wurden, um den der prädiktiven Maskenkarte entsprechenden Komplexitätsbewertungsindex zu erhalten.

10. Das Verfahren nach einem der Ansprüche 1 bis 9, ferner umfassend:

Erfassen eines ersten Datensatzes, wobei der erste Datensatz mindestens ein Maskenkartenmuster und ein dem Maskenkartenmuster entsprechendes Standardwafermuster umfasst; und
Trainieren des Wafermustererzeugungsmodells (11) unter Verwendung des ersten Datensatzes, um das vortrainierte Wafermustererzeugungsmodell (11) zu erhalten.

11. Das Verfahren nach Anspruch 10, wobei das Erfassen des ersten Datensatzes umfasst:

Durchführen einer Verarbeitung mit optischer Näherungskorrektur, OPC, an einem Chiplayoutmuster, um ein dem Chiplayoutmuster entsprechendes Maskenkartenmuster zu erhalten;
Erhalten eines dem Maskenkartenmuster entsprechenden Standardwafermusters durch ein zweites lithographisches physikalisches Modell, wobei das zweite lithographische physikalische Modell ein mathematisches physikalisches Simulationsmodell auf der Grundlage des Prinzips der Optik ist; und
Aufbauen des ersten Datensatzes gemäß dem Maskenkartenmuster und dem Standardwafermuster, die eine entsprechende Beziehung aufweisen.

12. Eine Trainingsvorrichtung (800) für ein lithographisches Maskenerzeugungsmodell (12), **dadurch gekennzeichnet, dass** die Vorrichtung umfasst:

ein Maskenerzeugungsmodul (810), eingerichtet zum Erzeugen einer prädiktiven Maskenkarte, die einem Chiplayout entspricht, durch ein lithographisches Maskenerzeugungsmodell (12), wobei das lithographische Maskenerzeugungsmodell (12) ein neuronales Netzwerkmodell zum Erzeugen der prädiktiven Maskenkarte ist;
ein Mustererzeugungsmodul (820), eingerichtet zum Erzeugen eines prädiktiven Wafermusters, das der prädiktiven Maskenkarte entspricht, durch ein vortrainiertes Wafermustererzeugungsmodell (11), wobei das Wafermustererzeugungsmodell (11) ein auf einem neuronalen Netzwerk basierendes Modell des maschinellen Lernens ist;
ein Verlustbestimmungsmodul (830), eingerichtet zum Bestimmen eines Modellgenauigkeitsbewertungsindex gemäß der prädiktiven Maskenkarte und zum Bestimmen eines Maskenqualitätsbewertungsindex gemäß dem prädiktiven Wafermuster; wobei der Modellgenauigkeitsbewertungsindex zum Darstellen einer Maskenvorhersagegenauigkeit des lithographischen Maskenerzeugungsmodells (12) verwendet wird und der Maskenqualitätsbewertungsindex zum Darstellen einer Qualität der prädiktiven Maskenkarte verwendet wird; zum Bestimmen eines Trainingsverlusts gemäß dem Modellgenauigkeitsbewertungsindex und dem Maskenqualitätsbewertungsindex; und

ein Parameteranpassungsmodul (840), eingerichtet zum Anpassen von mindestens einem Parameter des lithographischen Maskenerzeugungsmodells (12) gemäß dem Trainingsverlust.

**13.** Die Vorrichtung (800) nach Anspruch 12, wobei das Verlustbestimmungsmodul (830) ein Indexberechnungsuntermodul (831) und ein Verlustbestimmungsuntermodul (832) umfasst;

das Indexberechnungsuntermodul (831) ist eingerichtet zum Berechnen des Modellgenauigkeitsbewertungsindex gemäß einer Differenz zwischen der prädiktiven Maskenkarte und einer dem Chiplayout entsprechenden Standardmaskenkarte;

das Indexberechnungsuntermodul (831) ist eingerichtet zum Berechnen des Maskenqualitätsbewertungsindex gemäß einer Differenz zwischen dem prädiktiven Wafermuster und dem Chiplayout; und

das Verlustbestimmungsuntermodul (832) ist eingerichtet zum Bestimmen des Trainingsverlusts gemäß dem Modellgenauigkeitsbewertungsindex und dem Maskenqualitätsbewertungsindex.

**14.** Die Vorrichtung (800) nach Anspruch 13, ferner umfassend: ein Indexerfassungsmodul (850);

das Indexerfassungsmodul (850) ist eingerichtet zum Erfassen eines der prädiktiven Maskenkarte entsprechenden Komplexitätsbewertungsindex, wobei der Komplexitätsbewertungsindex eine Komplexität der prädiktiven Maskenkarte darstellt; und

das Verlustbestimmungsuntermodul (830) ist eingerichtet zum Bestimmen des Trainingsverlusts gemäß dem Modellgenauigkeitsbewertungsindex, dem Maskenqualitätsbewertungsindex und dem Komplexitätsbewertungsindex.

**15.** Ein computerlesbares Speichermedium, in dem ein Computerprogramm gespeichert ist, wobei das Computerprogramm, wenn es durch einen Computer ausgeführt wird, den Computer veranlasst, das Trainingsverfahren für ein lithographisches Maskenerzeugungsmodell (12) nach einem der Ansprüche 1 bis 11 auszuführen.

## Revendications

**1.** Un procédé d'entraînement d'un modèle de génération de masque lithographique (12), le procédé étant exécuté par un dispositif informatique, le procédé comprenant :

générer (301) une carte de masque prédictive correspondant à un layout de puce au moyen d'un modèle de génération de masque lithographique (12), le modèle de génération de masque lithographique (12) étant un modèle de réseau neuronal destiné à générer la carte de masque prédictive ;

générer (302) un motif de wafer prédictif correspondant à la carte de masque prédictive au moyen d'un modèle pré-entraîné de génération de motif de wafer (11), le modèle de génération de motif de wafer étant un modèle d'apprentissage automatique à base de réseau neuronal ;

déterminer (303) un indice d'évaluation de précision du modèle selon la carte de masque prédictive, et déterminer (303) un indice d'évaluation de qualité du masque selon le motif de wafer prédictif, l'indice d'évaluation de précision du modèle étant utilisé pour représenter une précision de prédiction de masque du modèle de génération de masque lithographique (12), et l'indice d'évaluation de qualité du masque étant utilisé pour représenter une qualité de la carte de masque prédictive ;

déterminer (303) une perte d'entraînement selon l'indice d'évaluation de précision du modèle et l'indice d'évaluation de qualité du masque ; et

ajuster (304) au moins un paramètre du modèle de génération de masque lithographique (12) selon la perte d'entraînement.

**2.** Le procédé selon la revendication 1, dans lequel déterminer (303) l'indice d'évaluation de précision du modèle selon la carte de masque prédictive, et déterminer (303) l'indice d'évaluation de qualité du masque selon le motif de wafer prédictif comprend :

calculer (3031) l'indice d'évaluation de précision du modèle selon une différence entre la carte de masque prédictive et une carte de masque standard correspondant au layout de puce ; et

calculer (3032) l'indice d'évaluation de qualité du masque selon une différence entre le motif de wafer prédictif et le layout de puce.

3. Le procédé selon la revendication 1 ou 2, comprenant en outre :

acquérir (3034) un indice d'évaluation de complexité correspondant à la carte de masque prédictive, l'indice d'évaluation de complexité représentant une complexité de la carte de masque prédictive ; et

déterminer (303) la perte d'entraînement selon l'indice d'évaluation de précision du modèle et l'indice d'évaluation de qualité du masque comprend :

déterminer (3035) la perte d'entraînement selon l'indice d'évaluation de précision du modèle, l'indice d'évaluation de qualité du masque, et l'indice d'évaluation de complexité.

4. Le procédé selon la revendication 3, dans lequel acquérir (3034) l'indice d'évaluation de complexité correspondant à la carte de masque prédictive comprend :

générer une pluralité de motifs de wafer correspondant à la carte de masque prédictive en utilisant un premier modèle physique lithographique sur la base d'une pluralité de paramètres de procédé différents, le premier modèle physique lithographique étant un modèle de simulation physique mathématique basé sur un principe d'optique ; et

déterminer, selon une différence entre la pluralité de motifs de wafer, l'indice d'évaluation de complexité correspondant à la carte de masque prédictive.

5. Le procédé selon la revendication 4, dans lequel générer la pluralité de motifs de wafer correspondant à la carte de masque prédictive en utilisant le premier modèle physique lithographique sur la base de la pluralité de paramètres de procédé différents comprend ;

générer un premier motif de wafer correspondant à la carte de masque prédictive en utilisant le premier modèle physique lithographique sur la base d'un premier paramètre de procédé ; et

générer un second motif de wafer correspondant à la carte de masque prédictive en utilisant le premier modèle physique lithographique sur la base d'un second paramètre de procédé, dans lequel une exposition du premier paramètre de procédé est inférieure à une exposition du second paramètre de procédé, et une défocalisation du premier paramètre de procédé est inférieure à une défocalisation du second paramètre de procédé ; et

déterminer, selon la différence entre la pluralité de motifs de wafer, l'indice d'évaluation de complexité correspondant à la carte de masque prédictive comprend :

calculer, selon une différence entre le premier motif de wafer et le second motif de wafer, l'indice d'évaluation de complexité correspondant à la carte de masque prédictive.

6. Le procédé selon la revendication 5, dans lequel calculer, selon la différence entre le premier motif de wafer et le second motif de wafer, l'indice d'évaluation de complexité correspondant à la carte de masque prédictive comprend :

effectuer une soustraction sur des matrices correspondant respectivement au premier motif de wafer et au second motif de wafer pour obtenir une première matrice de différence ; et

élever au carré un déterminant correspondant à la première matrice de différence pour obtenir l'indice d'évaluation de complexité correspondant à la carte de masque prédictive.

7. Le procédé selon la revendication 3, dans lequel acquérir (3034) l'indice d'évaluation de complexité correspondant à la carte de masque prédictive comprend :

générer l'indice d'évaluation de complexité correspondant à la carte de masque prédictive au moyen d'un modèle préentraîné d'évaluation de complexité (18), dans lequel le modèle d'évaluation de complexité est un modèle d'apprentissage automatique à base de réseau neuronal.

8. Le procédé selon la revendication 7, comprenant en outre :

acquérir un second ensemble de données, le second ensemble de données comprenant au moins un échantillon de carte de masque, et un indice standard d'évaluation de complexité correspondant à l'échantillon de carte de masque ; et

entraîner le modèle d'évaluation de complexité en utilisant le second ensemble de données pour obtenir le modèle pré-entraîné d'évaluation de complexité (18).

9. Le procédé selon la revendication 7, dans lequel le modèle de génération de motif de wafer (11) et le modèle d'évaluation de complexité partagent un même réseau d'extraction de caractéristiques, le modèle de génération de motif de wafer (11) comprenant le réseau d'extraction de caractéristiques et un réseau de prédiction de motif de wafer, et le modèle d'évaluation de complexité comprenant le réseau d'extraction de caractéristiques et un réseau d'évaluation de complexité ; et
générer l'indice d'évaluation de complexité correspondant à la carte de masque prédictive au moyen du modèle pré-entraîné d'évaluation de complexité (18) comprend :
traiter, au moyen du réseau d'évaluation de complexité, des informations de caractéristiques correspondant à la carte de masque prédictive obtenues par le réseau d'extraction de caractéristiques, pour obtenir l'indice d'évaluation de complexité correspondant à la carte de masque prédictive.

10. Le procédé selon l'une quelconque des revendications 1 à 9, comprenant en outre :

acquérir un premier ensemble de données, le premier ensemble de données comprenant au moins un échantillon de carte de masque, et un motif de wafer standard correspondant à l'échantillon de carte de masque ; et
entraîner le modèle de génération de motif de wafer (11) en utilisant le premier ensemble de données pour obtenir le modèle pré-entraîné de génération de motif de wafer (11).

11. Le procédé selon la revendication 10, dans lequel acquérir le premier ensemble de données comprend :

effectuer un traitement de correction optique de proximité, OPC, sur un échantillon de layout de puce, pour obtenir un échantillon de carte de masque correspondant à l'échantillon de layout de puce ;
obtenir un motif de wafer standard correspondant à l'échantillon de carte de masque au moyen d'un second modèle physique lithographique, le second modèle physique lithographique étant un modèle de simulation physique mathématique basé sur le principe de l'optique ; et
construire le premier ensemble de données selon l'échantillon de carte de masque et le motif de wafer standard ayant une relation de correspondance.

12. Un appareil d'entraînement (800) pour un modèle de génération de masque lithographique (12), **caractérisé en ce que** l'appareil comprend :

un module de génération de masque (810), configuré pour générer une carte de masque prédictive correspondant à un layout de puce au moyen d'un modèle de génération de masque lithographique (12), le modèle de génération de masque lithographique (12) étant un modèle de réseau neuronal destiné à générer la carte de masque prédictive ;
un module de génération de motif (820), configuré pour générer un motif de wafer prédictif correspondant à la carte de masque prédictive au moyen d'un modèle pré-entraîné de génération de motif de wafer (11), le modèle de génération de motif de wafer (11) étant un modèle d'apprentissage automatique à base de réseau neuronal ;
un module de détermination de perte (830), configuré pour déterminer un indice d'évaluation de précision du modèle selon la carte de masque prédictive, et déterminer un indice d'évaluation de qualité du masque selon le motif de wafer prédictif ; l'indice d'évaluation de précision du modèle étant utilisé pour représenter une précision de prédiction de masque du modèle de génération de masque lithographique (12), et l'indice d'évaluation de qualité du masque étant utilisé pour représenter une qualité de la carte de masque prédictive ; déterminer une perte d'entraînement selon l'indice d'évaluation de précision du modèle et l'indice d'évaluation de qualité du masque ; et
un module d'ajustement de paramètres (840), configuré pour ajuster au moins un paramètre du modèle de génération de masque lithographique (12) selon la perte d'entraînement.

13. L'appareil (800) selon la revendication 12, dans lequel le module de détermination de perte (830) comprend un sous-module de calcul d'indice (831) et un sous-module de détermination de perte (832) ;

le sous-module de calcul d'indice (831) est configuré pour calculer l'indice d'évaluation de précision du modèle selon une différence entre la carte de masque prédictive et une carte de masque standard correspondant au layout de puce ;
le sous-module de calcul d'indice (831) est configuré pour calculer l'indice d'évaluation de qualité du masque selon une différence entre le motif de wafer prédictif et le layout de puce ; et

le sous-module de détermination de perte (832) est configuré pour déterminer la perte d'entraînement selon l'indice d'évaluation de précision du modèle et l'indice d'évaluation de qualité du masque.

14. L'appareil (800) selon la revendication 13, comprenant en outre : un module d'acquisition d'indice (850) ;

le module d'acquisition d'indice (850) est configuré pour acquérir un indice d'évaluation de complexité correspondant à la carte de masque prédictive, l'indice d'évaluation de complexité représentant une complexité de la carte de masque prédictive ; et

le sous-module de détermination de perte (830) est configuré pour déterminer la perte d'entraînement selon l'indice d'évaluation de précision du modèle, l'indice d'évaluation de qualité du masque, et l'indice d'évaluation de complexité.

15. Un support de stockage lisible par ordinateur ayant un programme d'ordinateur stocké dans celui-ci, le programme d'ordinateur, lorsqu'il est exécuté par un ordinateur, amenant l'ordinateur à exécuter le procédé d'entraînement d'un modèle de génération de masque lithographique (12) selon l'une quelconque des revendications 1 à 11.

FIG. 1

FIG. 2

Generate a predictive mask map corresponding to a chip layout through a lithographic mask generation model — 301

Generate a predictive wafer pattern corresponding to the predictive mask map through a pre-trained wafer pattern generation model, the wafer pattern generation model being a machine learning model constructed based on a neural network — 302

Determine a model precision evaluation index according to the predictive mask map, determine a mask quality evaluation index according to the predictive wafer pattern, and determine a training loss according to the model precision evaluation index and the mask quality evaluation index — 303

Adjust a parameter of the lithographic mask generation model according to the training loss — 304

## FIG. 3

Generate a predictive mask map corresponding to a chip layout through a lithographic mask generation model — 301

Generate a predictive wafer pattern corresponding to the predictive mask map through a pre-trained wafer pattern generation model, the wafer pattern generation model being a machine learning model constructed based on a neural network — 302

Calculate the model precision evaluation index according to a difference between the predictive mask map and a standard mask map corresponding to the chip layout, the model precision evaluation index being used for representing a mask prediction precision of the lithographic mask generation model — 3031

Calculate the mask quality evaluation index according to a difference between the predictive wafer pattern and the chip layout, the mask quality evaluation index being used for representing a quality of the predictive mask map — 3032

Determine a training loss according to the model precision evaluation index and the mask quality evaluation index — 3033

Adjust a parameter of the lithographic mask generation model according to the training loss — 304

## FIG. 4

Generate a predictive mask map corresponding to a chip layout through a lithographic mask generation model  ⟋ 301

Generate a predictive wafer pattern corresponding to the predictive mask map through a pre-trained wafer pattern generation model, the wafer pattern generation model being a machine learning model constructed based on a neural network  ⟋ 302

Calculate the model precision evaluation index according to a difference between the predictive mask map and a standard mask map corresponding to the chip layout, the model precision evaluation index being used for representing a mask prediction precision of the lithographic mask generation model  ⟋ 3031

Calculate the mask quality evaluation index according to a difference between the predictive wafer pattern and the chip layout, the mask quality evaluation index being used for representing a quality of the predictive mask map  ⟋ 3032

Acquire a complexity evaluation index corresponding to the predictive mask map, the complexity evaluation index being used for representing a complexity of the predictive mask map  ⟋ 3034

Determine the training loss according to the model precision evaluation index, the mask quality evaluation index, and the complexity evaluation index  ⟋ 3035

Adjust a parameter of the lithographic mask generation model according to the training loss  ⟋ 304

FIG. 5

Mask map → Wafer pattern generation model (11) → Wafer pattern

Chip layout → Lithographic mask generation model (12) → Predictive mask map → Pre-trained wafer pattern generation model (11) / Pre-trained complexity evaluation model (18) → Wafer pattern

Back propagation

FIG. 6

Predictive mask map 701 → Encoding network 702 → Shared feature 703 → Wafer pattern prediction network 704 → Predictive wafer pattern 706 / complexity evaluation network 705 → Complexity evaluation index 707

FIG. 7

800

Mask generation module 810

Pattern generation module 820

Loss determination module 830

Parameter adjustment module 840

## FIG. 8

800

Mask generation module 810

Pattern generation module 820

Index acquisition module 850

Pattern generation submodule 851

Loss determination module 830

Index calculation submodule 831

Loss determination submodule 832

Data set acquisition module 860

Model training module 880

Parameter adjustment module 840

## FIG. 9

<u>1000</u>

1012

Network

1006

1008

Display

1009

Input device

Input/output controller
1010

1001

Central processing
unit

1011

Network interface
unit

1005

System bus

1004

1002

Random access
memory

Read-only
memory

1003

System memory

1007

1013

Operating system

1014

Application
program

Mass storage
device

1015

Another program
module

FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2020380362 A1